# EUROPEAN PATENT APPLICATION

(11) **EP 1 935 999 A2**
(43) Date of publication of application: **25.06.2008**
(21) Application number: 07121556.0
(22) Date of filing: 26.11.2007
(51) Int. Cl.: C22C 29/08, C23C 14/32, C23C 28/04, C23C 30/00

(54) **Coated cemented carbide endmill**

(30) Priority: 15.12.2006 SE 0602747
(71) Applicant: Sandvik Intellectual Property AB, 81181 Sandviken (SE)
(72) Inventor: Selinder, Torbjörn, 117 61 Stockholm (SE); Norgren, Susanne, 141 41 Huddinge (SE); Ahlgren, Mats, 187 67 Täby (SE); Sjöström, Ragnar, 121 44 Johanneshov (SE); Jonsson, Anders, 803 11 Gävle (SE)
(74) Representative: Hägglöf, Henrik

(57) **Abstract**

The present invention relates to a cemented carbide endmilling tool for semifinishing and finishing machining of hardened steels of HRC above 46, comprising a substrate and a wear resistant coating comprising a substrate and a wear resistant coating. The substrate, a, comprises 90-94 wt% WC in a binder phase of Co also containing Cr in such an amount that the Cr/Co weight ratio is 0.05-0.18. The wear resistant coating, b, is 1.8-9.5 µm thick, and comprises a first layer, c, of a hard and wear resistant refractory PVD AlMe nitride or carbonitride where Me is Zr, V, Nb, Cr or Ti having a thickness of 1.0-4.5 µm and an atomic fraction of Al to Me of 1.20-1.50, a second layer, d, of hard and wear resistant refractory PVD AlMe nitride or carbonitride where Me is Zr, V, Nb, Cr or Ti, having a thickness of 0.5-4.5 µm, and an atomic fraction of Al to Me of 1.30-1.70, and in between the first layer (c) and the second layer (d), a 0.05-1.0 µm thick low-A1 layer, (e), the thickness being less than 0.95 times the thickness of thinnest of the first layer (c) and the second layer (d), of an AlMe nitride or carbonitride where Me is Zr, V, Nb, Cr or Ti and an atomic fraction of Al to Me of 0-0.3.

## Description

The present invention relates to a metal cutting tool. More specifically the invention relates to a PVD coated cemented carbide endmill for semifinishing to finishing machining of hardened steels.

In chip forming machining of steel the requirements of high productivity, i.e., higher cutting speeds and feeds combined with increased tool lifetime, put severe demands on tool properties. When hardened, work piece steels normally have a hardness of between HRC 46 and 55, but may have hardness values of up to HRC 63 or even higher. For semifinishing and finishing operations of hardened steel so-called solid carbide tools are used. Such tools are produced, e.g., by grinding a cylindrical cemented carbide blank into a substrate of desired shape or providing a blank of desired shape by extrusion, which is subsequently coated by, e.g., physical vapour deposition (PVD). One very common application of solid carbide tools is endmilling of components, dies and moulds, but it is usually not possible to cover the whole hardness range with one single tool grade.

Endmilling of hardened steels generates large amounts of heat, which causes high temperatures at the cutting edge. Very often the shape of the machined component is such that shank overhangs are large. Both of these factors make necessary the use of hard cemented carbide grades that do not soften appreciably at the elevated temperatures at hand and that are rigid so that tool bending is negligible. The need for a harder grade has, however, to be balanced against the lowered bulk toughness that follows. For general machining, the typical substrate hardness is below 1600 HV3, whereas in hard part machining typical HV3 values range from 1700 up to in excess of 1800. A severe problem here is that substrate brittleness causes chipping problems of the sharply ground cutting edge, which is not easily remedied by standard PVD coatings. Any cracks that occur in the coating due to the machining tend to propagate through the entire coating thickness. At the interface to the substrate these cracks may serve as crack initiation points for substrate bulk fracture.

Cemented carbide grades for endmilling applications generally contain fine grain WC, γ-phase which is a solid solution of generally TiC, NbC, TaC and WC, and binder phase, generally Co or Ni. Cemented carbides having a fine grain size <1 µm are produced through the incorporation of grain growth inhibitors such as V, Cr, Ti, Ta and combinations thereof in the initial powder blend. Typical inhibitor additions are 0.5 to 5 wt-% of the binder phase. In addition the sintering temperature must be low, ~1350-1390 °C, in order to further restrict grain coarsening. To generate a sintered substrate with a grain size of 0.6 µm, in general, the WC powder is essentially finer, typically 0.2-0.3 µm.

PVD coatings for endmills are, for instance, (Ti,Al)N single layers, with high hardness and wear resistance. By the use of intense ion bombardment of the coating during its growth, PVD layers have high residual stress levels, of the order of at least 2000 MPa compressive, and usually higher than 3000 MPa compressive. A compressive stress is in general considered an advantage because considerable mechanical load on the tool is needed to initiate a crack in the coating. At the same time, however, a maximum coating thickness of around 3 µm is imposed due to the high stress and limited coating adhesion.

Improved tool toughness may be achieved with coating design, e.g., with non-periodic TiN+(Ti,Al)N multilayers such as disclosed in EP 983 393. In these the average Al contents are lower than in the case of single layer coatings, which compromises the wear resistance.

It is an object of the present invention to provide a coated cemented carbide endmill with improved wear resistance without sacrificing toughness and edge security particularly useful for semifinishing and finishing in steels with hardnesses of HRC 46-63, and above.

This object is solved by providing a cemented carbide insert consisting of a WC+Co-substrate with fine grain size provided with a PVD coating that achieves optimum wear resistance and increased cutting edge toughness by means of its layer structure.

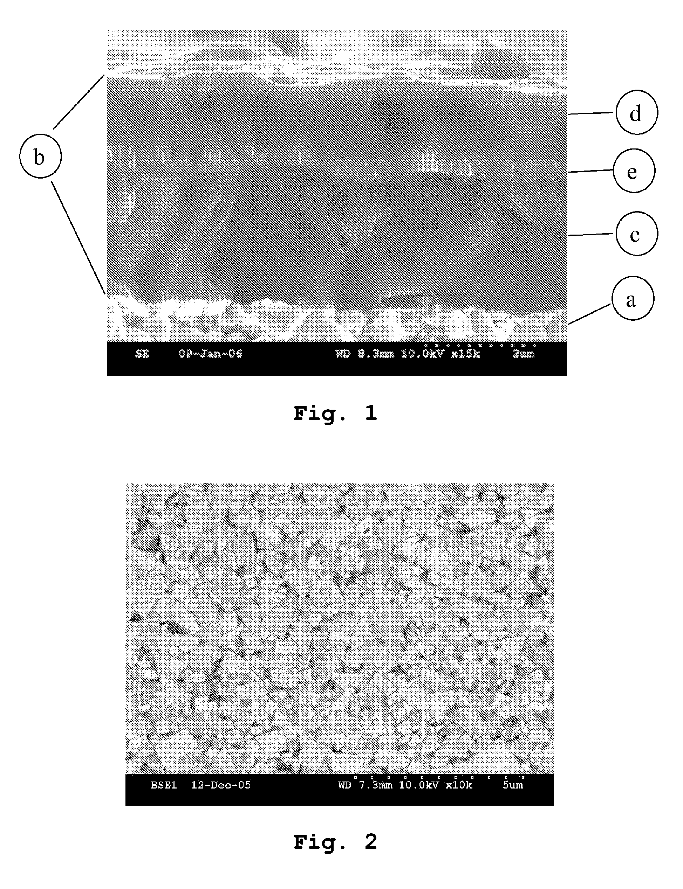

Fig. 1 shows a Scanning Electron Microscope (SEM) micrograph of a fracture section of an exemplary end mill according to the invention in which
a - substrate
b - coating
c - first layer
d - second layer
e - low Al-layer.

Fig. 2 shows a SEM micrograph of an exemplary substrate according to the invention.

Fig. 3 shows a light optical micrograph of a cross section micrograph of an exemplary endmill according to the invention.

Fig. 4 shows a SEM micrograph of a worn edge of an exemplary endmill according to the invention.

Fig. 5 shows a SEM micrograph of a worn edge of an end mill according to prior art.

It has surprisingly been found that by sandwiching a low-Al containing (Ti,Al)N layer, having the unexpected property of being essentially stressless, between two high-Al containing (Ti,Al)N layers having high compressive residual stresses edge chipping is suppressed. Thus, the use of harder substrate grades as well as thicker coatings, and thanks to that, more wear resistant coatings are enabled.

According to the present invention there is provided a coated solid carbide endmill for semifinishing and finishing machining of hardened steels of HRC 46-63, and above, comprising a cemented carbide substrate and a wear resistant coating, wherein
the substrate, (a), comprises 90-94 wt%, preferably 91-93 wt%, WC in a binder phase of Co also containing Cr in such an amount that the Cr/Co weight ratio is 0.05-0.18, preferably 0.06-0.16, more preferably 0.07-0.14, most preferably 0.075-0.13, and with a coercivity of >22 kA/m, preferably 25-30 kA/m, and
the wear resistant coating, (b), is 1.8-9.5 µm, preferably 2.5-6.0 µm thick, comprising
a first layer, (c), of a hard and wear resistant refractory PVD AlMe nitride or carbonitride where Me is Zr, V, Nb, Cr or Ti, preferably Ti having a thickness of 1.0-4.5 µm, preferably 2.0-3.0 µm, and an atomic fraction of Al to Me of 1.20-1.50, preferably 1.30-1.40,
a second layer, (d), of hard and wear resistant refractory PVD AlMe nitride or carbonitride where Me is Zr, V, Nb, Cr or Ti, preferably Ti having a thickness of 0.5-4.5 µm, preferably 1.0-2.0 µm, and an atomic fraction of Al to Me of 1.30-1.70, preferably 1.50-1.60, and
in between the first and the second layer, a 0.05-1.0 µm, preferably 0.1-0.7 µm, thick low-Al layer, (e), the thickness of layer (e) being less than 0.95 times, preferably less than 0.8 times, most preferably less than 0.5 times, the thickness of thinnest of the first layer (c) and the second layer (d), of an AlMe nitride or carbonitride where Me is Zr, V, Nb, Cr or Ti, preferably Ti, and an atomic fraction of Al to Me of 0-0.3, preferably 0-0.05, most preferably MeN.

The atomic fraction of Al to Me in the layers is measured by averaging at least four point analyses in cross section transmission electron microscopy (TEM).

In a preferred embodiment, the first layer (c) and the second layer (d) both have crystallites of the cubic rock salt structure with a grain size less than 50 nm, preferably less than 40 nm. The low-Al layer (e) has a crystallite grain size larger than 40 nm, preferably larger than 50 nm perpendicular to the growth direction and larger than 100 nm parallel to the growth direction, i.e., having columnar growth, and most preferably extending in the growth direction throughout its thickness.

X-ray diffraction techniques, more specifically the sin ²ψ method (I.C. Noyan, J.B. Cohen, Residual Stress Measurement by Diffraction and Interpretation, Springer-Verlag, New York, 1987, pp 117-130), is used for determining the residual stress.

In a further preferred embodiment the first layer (c) has a residual compressive stress >1000 MPa, preferably 1800 to 3500 MPa, the second layer (d) has a residual compressive stress >1000 MPa, preferably 1800 to 3500 MPa and the low-Al layer (e) has a residual stress of an absolute value <600 MPa (i.e. being compressive or tensile), preferably <300 MPa, more preferably <80 MPa.

Optionally applied onto the second layer (d) are further layers which may be used for further improving wear resistance, cosmetic appearance or for wear detection purposes.

The present invention further relates to a method of making a cemented carbide endmill with a composition according to above including the following steps:
- wet milling submicron powders of tungsten carbide cobalt, at least one of Cr₃C₂, Cr₂₃C₆ and Cr₇C₃ to obtain a slurry,
- drying the slurry to obtain a powder,
- pressing the powder into rods,
- sintering the rods in vacuum or in nitrogen as described in EP-A-1 500 713, and
- optionally performing an isostatic gas pressure step during sintering temperature or at the final stage of sintering.

The so obtained cemented carbide rods are centerless ground cylindrical to h6 tolerance. Flutes are ground using diamond wheels with emulsion cutting fluid.

The as-ground solid carbide endmill substrates are wet cleaned. The substrates are subjected to a PVD coating process in a coater using reactive arc evaporation type PVD equipment containing metal evaporation MeAl-sources with suitable composition to obtain the desired Al/Me atomic ratios, arranged such to coat the full charge homogeneously. The MeAl-sources can, e.g., be three single targets arranged so that each target coats the full charge homogeneously or, as an alternative, six MeAl-sources can be arranged pairwise so that each pair coats the full charge homogeneously. However, other number of targets and arrangements are within the scope of the invention. The coater is evacuated, followed by the steps of heating and plasma etching in order to further clean the tools, and to condition their surfaces by removing excess binder phase from the WC surface. By metal evaporation whilst maintaining a partial pressure of nitrogen in the recipient i.e., the coating furnace or vacuum vessel in which the deposition process takes place, and using the appropriate selection of active evaporation sources and rates the following layers are deposited:
a wear resistant coating, (b), is 1.8-9.5 µm, preferably 2.5-6.0 µm thick, comprising
a first layer, (c), of a hard and wear resistant refractory PVD AlMe nitride or carbonitride where Me is Zr, V, Nb, Cr or Ti, preferably Ti having a thickness of 1.0-4.5 µm, preferably 2.0-3.0 µm, and an atomic fraction of Al to Me of 1.20-1.50, preferably 1.30-1.40, with process parameters: arc current 50-200 A, preferably 120-160 A in the equipment, N₂-pressure 5-50 µbar, preferably 7-20 µbar, and deposition temperature 400-700°C, preferably 550-650°C, and a substrate bias of -150 to -300 V, preferably -170 to -230 V.
a second layer, (d), of hard and wear resistant refractory PVD AlMe nitride or carbonitride where Me is Zr, V, Nb, Cr or Ti, preferably Ti having a thickness of 0.5-4.5 µm, preferably 1.0-2.0 µm, and an atomic fraction of Al to Me of 1.30-1.70, preferably 1.50-1.60, with process parameters: arc current 50-200 A preferably 120-160 A in the equipment, N₂-pressure 5-50 µbar, preferably 7-20 µbar, and deposition temperature 400-700°C, preferably 550-650°C, and a substrate bias of -50 to -140 V, preferably -80 to -120 V.
in between the first and the second layer, a 0.05-1.0 µm, preferably 0.1-0.7 µm, thick low-Al layer, (e), the thickness of layer (e) being less than 0.95 times, preferably less than 0.8 times, most preferably less than 0.5 times, the thickness of thinnest of the first layer (c) and the second layer (d), of an AlMe nitride or carbonitride where Me is Zr, V, Nb, Cr or Ti, preferably Ti, and an atomic fraction of Al to Me of 0-0.3, preferably 0-0.05, most preferably MeN with temperature 400-700°C, preferably 550-650°C, N₂-pressure 5-50 µbar, preferably 7-20 µbar, the substrate bias -30 to -150 V preferably -70 to -120 V and the arc current 80-210 A, preferably 140-190 A.

The coating can also be deposited by other PVD technologies, such as, magnetron sputtering, dual magnetron sputtering or arc technology.

### Example 1.

Tungsten carbide powder with an FSSS grain size of 0.9 µm, 7 wt% very fine grained cobalt powder and 0.7 wt-% Cr added as H.C.Starck fine grained Cr₃C₂-powder, were wet milled together with conventional pressing agents. After milling and spray drying the powder was pressed into 6 mm diameter rods and sintered at 1410 °C and 40 bar Ar gas pressure. The sintered material had a coercivity of 28 kA/m.

The so obtained cemented carbide rods were centerless ground cylindrical to h6 tolerance. Flutes were ground using diamond wheels with emulsion cutting fluid.

The as-ground solid carbide endmill substrates were wet cleaned and subjected to a PVD coating process according to the following. The substrates were loaded into a reactive arc evaporation type PVD equipment chamber containing six metal evaporation sources, arranged pairwise so that each pair would coat the full charge homogeneously. One pair of evaporators had Ti metal targets and the other two pairs had AlTi alloy targets having a composition ratio Al/Ti of 2. The chamber was evacuated, followed by the steps of heating and plasma etching in order to further clean the tools, and to condition their surfaces by removing excess binder phase from the WC surface. By metal evaporation whilst maintaining a partial pressure of nitrogen in the recipient, and using the appropriate selection of active evaporation sources and -rates TiN and (Ti,Al)N alloy layers were deposited at a temperature of 600°C. The process conditions during the deposition steps were as below:

**Table 1.**

| Layer | Target | Time [min] | Arc current [A] | Bias [V] | Pressure [µbar] | N₂ [sccm] | Ar [sccm] |
|---|---|---|---|---|---|---|---|
| c | 4xAlTi | 130 | 140 | -200 | 10 N₂ | | |
| e | 2xTi | 25 | 170 | -100 | | 800 | 400 |
| d | 4xAlTi | 65 | 140 | -100 | 10 N₂ | | |

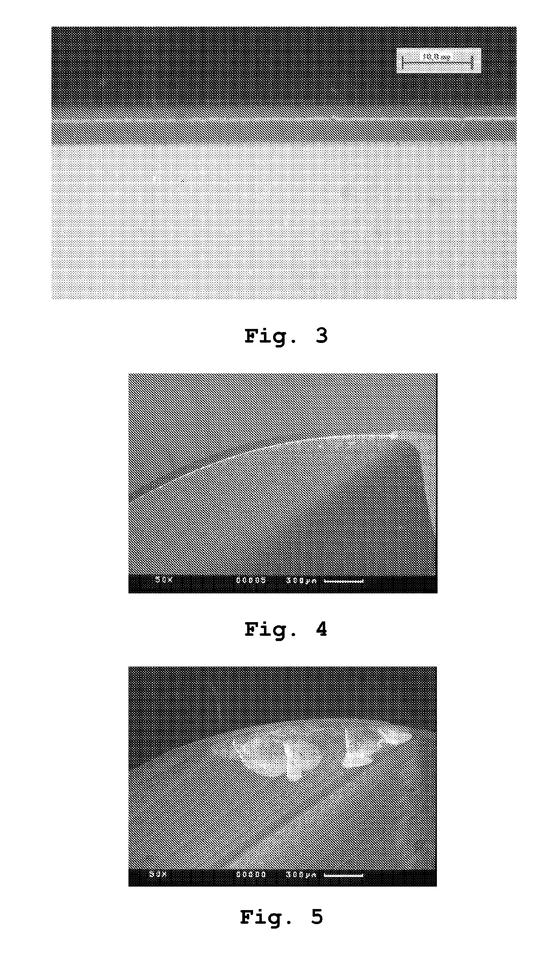

The so manufactured and coated solid carbide endmills were analysed metallographically. Cross sections were prepared by cutting the endmill 10 mm from the tip, followed by mechanical grinding and polishing by diamond grit. A typical section of coating and substrate is shown in the optical micrograph in Fig. 3. The coating thicknesses indicated in Table 1 were measured on the cylindrical land, i.e., clearance side, more than 0.2 mm away, and less than 1.0 mm, from the cutting edge.

X-ray diffraction techniques, more specifically the sin²ψ method, (I.C. Noyan, J.B. Cohen, Residual Stress Measurement by Diffraction and Interpretation, Springer-Verlag, New York, 1987 (pp 117-130)), was used for determining the residual stress in the three layers. The results are reported in Table 2.

Thin film transmission electron microscopy equipped with an EDS spectrometer was used to determine the Al/Ti atomic ratio as an average of four point analyses and grain size in the three layers, see Table 2.

**Table 2.**

| Layer | Coating type | Thickness [µm] | Al/Ti atomic ratio | Grain size [nm] | Residual stress [MPa] |
|---|---|---|---|---|---|
| c | (Ti,Al)N | 2.4 | 1.34 | 35 | -2400* |
| e | TiN | 0.2 | 0 | columnar 75x150 | -80 |
| d | (Ti,Al)N | 1.6 | 1.56 | 30 | -2300 |

| | | | | | |
|---|---|---|---|---|---|
| *Estimated | | | | | |

### Example 2.

Endmills from Example 1 were tested and compared with endmills of a commercially available grade for the intended application area. Wear resistance test in very hard steel; a wear resistant and toughness demanding semifinishing test with 30% stepover. The test represents the upper range in terms of work piece hardness.

| Type of test | Cavity milling, size 48x48 mm, using diameter 1 mm BNE |
|---|---|
| Tool life criterion | Max flank wear 0.20 mm |
| Work piece | Uddeholm Vanadis 10, HRC 62 |
| Cutting speed, V_{c} (m/min) | 60 |
| Tooth feed, f_{z} (mm/edge) | 0.11 |
| Engagement, ap/aₑ (mm) | 0.3/0.3 |
| Cooling | Dry |
| Machine | Modig MD 7200 |
| | |

| Result: | Tool life in minutes |
|---|---|
| Invention (from Example 1) | 29 |
| Commercial grade | 22 |

There is a significant improvement in comparison to the commercial grade which is optimised for this range of work piece hardness. This clearly expresses the superior wear resistance of the invented tool.

### Example 3.

Endmills from Example 1 were tested and compared with endmills of a commercially available grade for the intended application area. This is a toughness demanding sidemilling test in hardened die steel. The machining situation was a very typical application. It represents, in terms of work piece hardness, the lower end of the application area for endmilling in hardened steels.

| Type of test | Sidemilling with a six-fluted, diameter 10 mm corner endmill |
|---|---|
| Tool life criterion | V_{b} max 0.20 mm |
| Work piece | Uddeholm Orvar Supreme HRC 48 |
| Cutting speed, V_{c} (m/min) | 375 |
| Tooth feed, f_{z} (mm/edge) | 0.10 |
| Engagement, aₚ/aₑ (mm) | 10/0.5 |
| Cooling | Compressed air |
| Machine | Modig MD 7200 |
| | |

| Result: | Tool life in milled distance |
|---|---|
| Invention (from Example 1) | 750 m |
| Commercial grade | 500 m |

The improvement compared to the commercial grade, which is designed for hard part machining, shows the excellent width of the application area for the invented endmill.

### Example 4.

Endmills from Example 1 were tested and compared with endmills of a commercially available grade for the intended application area. Machining of two identical tools for die and mould applications. In this application, edge security and toughness is essential. It represents a vital customer value to be able to machine a complete part without tool change.

| Type of test | Finishing of mould using diameter 6 mm ball nosed endmill |
|---|---|
| Tool demand | > 296 min life time, completion of one part |
| Work piece | Uddeholm Orvar Supreme, HRC 51 |
| Cutting speed, rpm | 12468 rpm |
| Tooth feed, f_{z} mm/edge | 0.08 mm |
| Engagement, ap/aₑ mm | 0.07/0.1 mm |
| Cooling | dry |
| | |

| Result: | |
|---|---|
| Invention (from Example 1) | see Fig. 4 |
| Commercial grade | see Fig. 5 |

The result of this test was that the commercial grade tool failed to meet the demanded tool life, whereas the invented tool finished the operation with very little wear. The result clearly shows a superior wear resistance of the invention and ability to sustain an integer cutting edge compared to the commercial grade tool.

### Example 5.

Field test at customer, manufacturing of hot forge dies in hardened tools steel HRC 53. The machining was done using three different steps using ball nosed endmills (BNE) of diameters 10, 6, and 2 mm.

| Type of test | Tool life test using diameter 10, 6, and 2 mm BNE |
|---|---|
| Tool life criterion | Stopped cutting |
| Work piece | Uddeholm Orvar Supreme HRC 53 |
| Cutting speed, V_{c} (m/min) | 110, 110, and 107 respectively |
| Spindle speed, (rpm) | 35000, 12500, and 6300 respectively |
| Tooth feed, f_{z} (mm/edge) | 0.05, 0.11, and 0.70 respectively |
| Engagement, aₚ/aₑ (mm) | 0.07/0.05, 0.35/1.20, and 0.8/2.20 respectively |
| Cooling | Oil Mist |
| Machine | Modig MD 7200 |

**Table 3. Result: Tool life in minutes**

| Layer | BNE 10 mm | BNE 6 mm | BNE 2 mm |
|---|---|---|---|
| Invention (from Example 1) | 374 | 428 | 1202 |
| Commercial grade | 130 | 330 | 660 |

The results indicated a significant improvement in tool live for the endmill according to the invention.

## Claims

1. Cemented carbide endmilling tool for semifinishing and finishing machining of hardened steels of HRC above 46, comprising a substrate and a wear resistant coating **characterized in that**
- the substrate (a) comprises 90-94 wt%, preferably 91-93 wt%, WC in a binder phase of Co also containing Cr in such an amount that the Cr/Co weight ratio is 0.05-0.18, preferably 0.06-0.16, more preferably 0.07-0.14, most preferably 0.075-0.13 and
the wear resistant coating (b) is 1.8-9.5 µm thick, preferably 2.5-6.0 µm thick, comprising
a first layer (c) of a hard and wear resistant refractory PVD AlMe nitride or carbonitride where Me is Zr, V, Nb, Cr or Ti, preferably Ti, having a thickness of 1.0-4.5 µm, preferably 2.0-3.0 µm, and an atomic fraction of Al to Me of 1.20-1.50, preferably 1.30-1.40,
a second layer (d) of hard and wear resistant refractory PVD AlMe nitride or carbonitride where Me is Zr, V, Nb, Cr or Ti, preferably Ti, having a thickness of 0.5-4.5 µm, preferably 1.0-2.0 µm, and an atomic fraction of Al to Me of 1.30-1.70, preferably 1.50-1.60, and
in between the first and the second layer, a 0.05-1.0 µm, preferably 0.1-0.7 µm, thick low-Al layer (e) the thickness of layer (e) being less than 0.95 times, preferably less than 0.8 times, most preferably less than 0.5 times, the thickness of thinnest of the first layer (c) and the second layer (d), of an AlMe nitride or carbonitride where Me is Zr, V, Nb, Cr or Ti, preferably Ti, and an atomic fraction of Al to Me of 0-0.3, preferably 0-0.05, most preferably MeN.

2. Cemented carbide endmilling tool according to the preceding claim **characterized in that** the Cr/Co ratio of the binder phase is 0.07-0.14.

3. Cemented carbide endmilling tool according to the preceding claims **characterized in that** the first layer and the second layer both have crystallites of the cubic rock salt structure with a grain size less than 50 nm, preferably less than 40 nm.

4. Cemented carbide endmilling tool according to the preceding claims **characterized in that** the low-Al layer(e) has a crystallite grain size larger than 40 nm, preferably larger than 50 nm perpendicular to the growth direction and larger than 100 nm parallel to the growth direction.

5. Cemented carbide endmilling tool according to the preceding claims **characterized in that** the first layer (c) has a residual compressive stress >1000 MPa, preferably 1800 to 3500 MPa, and that the second layer (d) has a residual compressive stress >1000 MPa, preferably 1800 to 3500 MPa.

6. Cemented carbide endmilling tool according to the preceding claims **characterized in that** the low-Al layer (e) has a residual stress has an absolute value <600 MPa, being compressive or tensile, preferably <300 MPa, more preferably <80 MPa.

7. Method of making a cemented carbide endmilling tool for semifinishing and finishing machining of hardened steels of HRC above 46, **characterized in** the following steps
- providing a cemented carbide endmill blank with a composition comprising 90-94 wt%, preferably 91-93 wt%, WC in a binder phase of Co also containing Cr in such an amount that the Cr/Co weight ratio is 0.05-0.18, preferably 0.06-0.16, more preferably 0.07-0.14, most preferably 0.075-0.13,
- wet milling submicron powders of tungsten carbide cobalt, at least one of Cr₃C₂, Cr₂₃C₆ and Cr₇C₃ to obtain a slurry,
- drying the slurry to obtain a powder,
- pressing the powder into rods,
- sintering the rods in vacuum or in nitrogen, and
- optionally performing an isostatic gas pressure step during sintering temperature or at the final stage of sintering
- grinding the rods cylindrical to h6 tolerance
- grinding flutes using diamond wheels with emulsion cutting fluid
- depositing whilst maintaining a partial pressure of nitrogen in the recipient, and using the appropriate selection of active evaporation sources and rates
- a wear resistant coating (b) is 1.8-9.5 µm thick, preferably 2.5-6.0 µm thick, comprising
- a first layer (c) of a hard and wear resistant refractory PVD AlMe nitride or carbonitride where Me is Zr, V, Nb, Cr or Ti, preferably Ti, having a thickness of 1.0-4.5 µm, preferably 2.0-3.0 µm, and an atomic fraction of Al to Me of 1.20-1.50, preferably 1.30-1.40, with process parameters: arc current 50-200 A, preferably 120-160 A, in used equipment, N₂-pressure 5-50 µbar, preferably 7-20 µbar, and deposition temperature 400-700°C, preferably 550-650°C, and a substrate bias of -150 to -300V, preferably -170 to -230 V,
- a second layer (d) of hard and wear resistant refractory PVD AlMe nitride or carbonitride where Me is Zr, V, Nb, Cr or Ti, preferably Ti, having a thickness of 0.5-4.5 µm, preferably 1.0-2.0 µm, and an atomic fraction of Al to Me of 1.30-1.70, preferably 1.50-1.60, with process parameters: arc current 50-200 A, preferably 120-160 A, in used equipment, N₂-pressure 5-50 µbar, preferably 7-20 µbar, and deposition temperature 400-700°C, preferably 550-650°C, and a substrate bias of -50 to -140 V, preferably -80 to -120 V, and
- in between the first layer (c) and the second layer (d), a 0.05-1.0 µm, preferably 0.1-0.7 µm, thick low-Al layer (e) with temperature 400-700°C, preferably 550-650°C, the substrate bias - 30 to 150 V, preferably -70 to 120 V, and the arc current 80-210 A, preferably 140-190 A.
